Europäisches Patentamt

European Patent Office

Office européen des brevets

(11) Publication number: 0 200 462
A2

## EUROPEAN PATENT APPLICATION

(21) Application number: 86303029.2

(22) Date of filing: 22.04.86

(51) Int. Cl.4: H01R 33/06

(30) Priority: 22.04.85 US 725565

(43) Date of publication of application:
10.12.86 Bulletin 86/45

(84) Designated Contracting States:
BE DE FR GB LU NL

(71) Applicant: Savage, John M., jr.
8118 W. 83rd Street Apt. C
Playa Del Rey California 90291(US)

(72) Inventor: Savage, John M., jr.
8118 W. 83rd Street Apt. C
Playa Del Rey California 90291(US)

(74) Representative: Hartley, David et al
c/o Withers & Rogers 4 Dyer's Buildings
Holborn
London, EC1N 2JT(GB)

(54) Circuit component mount.

(57) Structure (10) usable in an assembly including a circuit component (14) such as a light unit or LED, having a base (24) and terminal or terminals (21) projecting endwise from the base. At least one end portion of a body (11) of the structure (10) is adapted to provide support for the base (24) of the circuit component (14), and the body (11) defines a cavity or cavities (15, 16) there being contact structure - (26) in the latter for removable endwise reception of the circuit component terminal or terminals (21) to establish electrical contact therewith when the base of the circuit component is supported by the body end portion (13a). An auxiliary terminal or terminals - (34) is carried by the body (11) and projects exteriorly therefrom for reception by a circuit board - (36), thereby to mount the body (11) and circuit component (14) on the circuit board. The auxiliary terminal or terminals have an electrical connection with the contact structure.

## CIRCUIT COMPONENT MOUNT

This invention relates generally to the mounting of circuit components on circuit boards; more particularly it concerns a mount that has multiple modes of connection to a circuit board as well as multiple modes of connection to a circuit component, such as an LED, for example.

U.S. Patent 4,195,330, describes a means for mounting a light unit such as an LED, for example, to a panel, with unusual advantage.

There is presently a need for mounting circuit components to circuit boards in different ways or positions. To my knowledge, no way was known, prior to the present invention to attach a circuit component such as an LED to a discrete mount, im multiple modes, facilitating its positioning in different ways to a circuit board, so to provide such a mount which optionally connects to the board in different modes, thereby to achieve surprisingly advantageous results as will appear.

It is a major object of the invention to facilitate the above described multiple attachment and mounting modes, with attendant further advantages including ease and rapidity of mounting and assembly, low bulk and small overall size, elimination of the need for soldered connection of the circuit component to the mount, and no weight imposition on LED leads by circuit components connected to such leads.

In accordance with the present invention, I propose apparatus adapted for use in an assembly that includes circuit components, particularly a light unit, having a base, and terminal means projecting from the base, the apparatus comprising a body having at least one end portion adapted to provide support to the base of the circuit component, the body defining cavity means, and there being contact structure in the cavity means for removable endwise reception of the circuit component terminal means to establish electrical contact therewith when the base of the circuit component is supported by the body end portion, and auxiliary terminal means carried by the body and projecting exteriorly therefrom for reception by a circuit board, thereby to mount the body and circuit component on the circuit board the auxiliary terminal having electrical connection with the contct structure.

Typically, the cavity means extends through the body and opens at opposite ends defined by the body to expose the contact structure to endwise reception of the terminal means via one or the other of the said opposite ends, the auxiliary terminal means projects sidewardly, outwardly of the body, and closer to one of the body ends than the other of the body ends; and the circuit component such as a light unit has its base located at the said one end of the body, with the circuit component terminal means in electrical contact with the contact structure within the cavity means. Alternatively, the circuit component has its base located at the said other end of the body, with the light unit terminal means in electrical contact with the contact structure, within the cavity means.

Rather than projecting sidewardly from the body, the terminal means may project endwise of and from one end of the body; and the circuit component may have its base located at the opposite end of the body, with the circuit component terminal means in electrical contact with the contact structure, within the cavity means.

Further, and as will appear, the cavity means may include two spaced, generally parallel cavities respectively containing first and second contacts defined by the contact structure, the contacts including spring fingers to pressurally engage first and second circuit component terminals respectively received in the first and second cavities. The circuit or light component terminal means typically projects at least substantially through the cavity and has an end portion remote from the base and retained by the body against relative displacement endwise of the cavity.

Also, the contact structure and auxiliary terminal structure may be integral and attached to the universal mount body, and may be defined by a single metallic sheet having tab means anchoring the sheet to the body.

These and other objects and advantages of the invention, will become apparent from the following description of the illustrative embodiment, with reference to the accompanying drawings, in which:

Figure 1 is a sectional side elevation taken through a circuit component mount;

Figure 2 is a right end elevation taken on lines 2-2 of Figure 1;

Figure 3 is a left end elevation taken on lines 3-3 of Figure 1;

Figure 4 is a view like Figure 1, but showing a light unit attached to one end of the Figure 1 mount, the latter sidewardly attached to a circuit board;

Figure 5 is another view like Figure 1, but showing a light unit attached to the opposite end of the Figure 1 mount, the latter sidewardly attached to a circuit board;

Figure 6 is a view like Figure 1, showing a modified circuit component mount;

Figure 7 is a right end elevation taken on lines 7-7 of Figure 6;

Figure 8 is a left end elevation taken on lines 8-8 of Figure 6;

Figure 9 is a view like Figure 6, but showing a light unit attached to one end of the Figure 6 mount, the latter endwise attached to a circuit board;

Figure 10 is another view like Figure 6, but showing a light unit attached to the opposite end of the Figure 6 mount, the latter endwise attached to a circuit board;

Figure 11 is a view like Figure 9, but showing the provision of a spacer between the light unit and the mount;

Figure 12 is a side elevation showing contact structure as usable in the Figure 1 mount;

Figure 13 is an end elevation taken on lines 13-13 of Figure 12;

Figure 14 is a view of the Figure 12 contact structure in as-stamped, flat condition;

Figure 15 is a view like Figure 12, showing modified contact structure as usable in the Figure 6 mount;

Figure 16 is an end view taken on lines 16-6 of Figure 15;

Figure 17 is a view of the Figure 15 contact structure in as-stamped, flat condition;

Figure 18 is a side elevational, sectional view of the universal mount body, prior to reception of contact structure;

Figure 19 is a right end elevational view of the Figure 18 mount;

Figure 20 is a left end elevational view of the Figure 18 mount; and

Figure 21 is a view taken in sections on lines 21-21 of Figure 20.

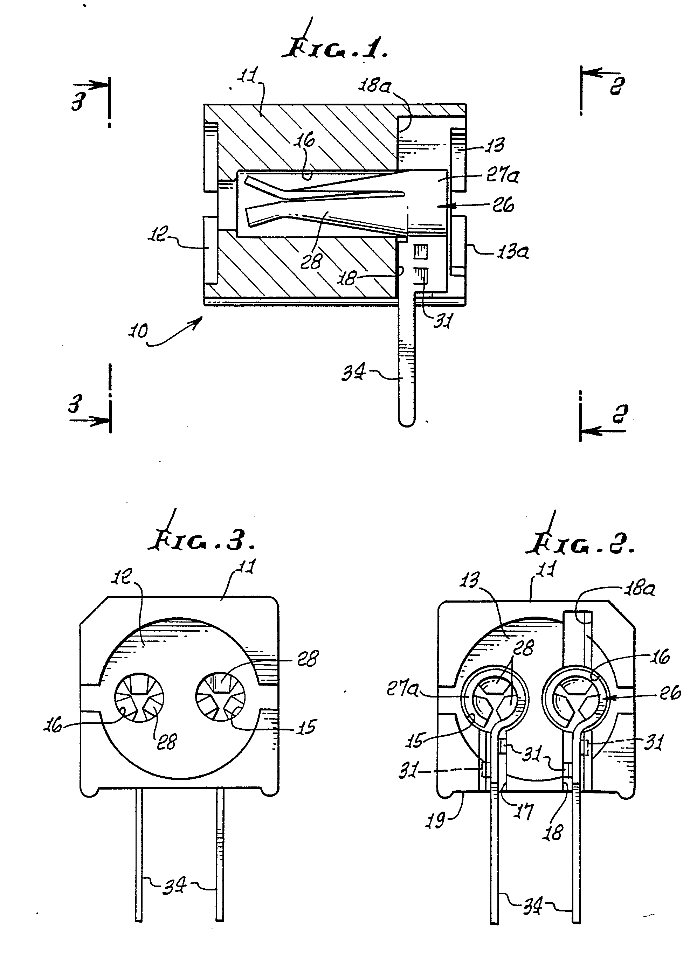

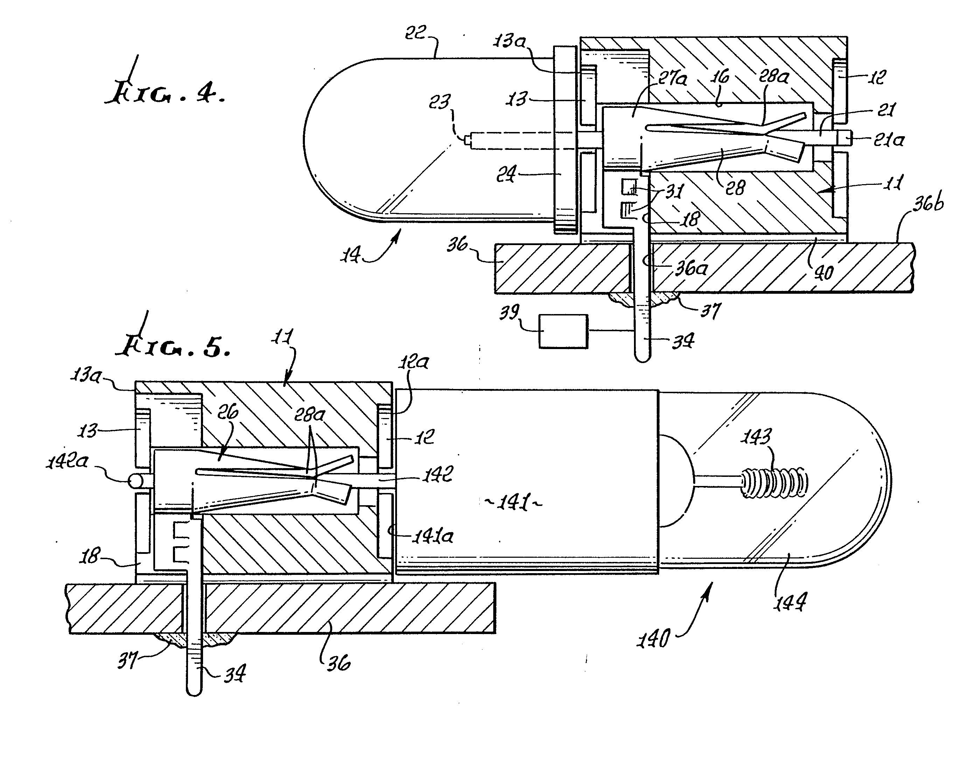

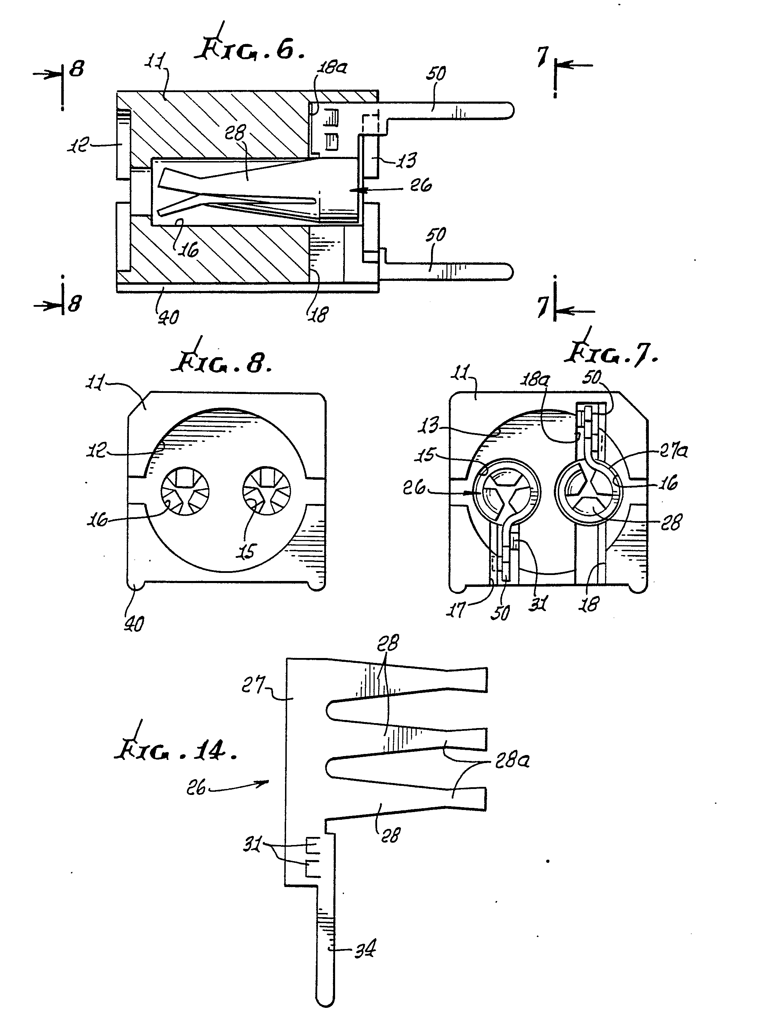

Referring first to Figures 1 to 5, and 18 to 21, a mount 10 includes a one-piece moulded plastic body 11 having recessed opposite ends 12 and 13 adapted to serve as supports for circuit components such as light units, one such light unit for example comprising an LED 14. The body defines cavity means such as the two longitudinally extending, laterally spaced cavities 15 and 16 that extend endwise oppositely, and in parallel relation between recessed opposite ends 12 and 13. Also, the two cavities 17 and 18 respectively extend transversely between the cavities 15 and 16 and one side 19 of the mount body, adjacent recessed end 13. A complementary cavity 18a extends in transverse alignment with cavity 17, but at the opposite side of cavity 15. Figure 20 shows corresponding structure.

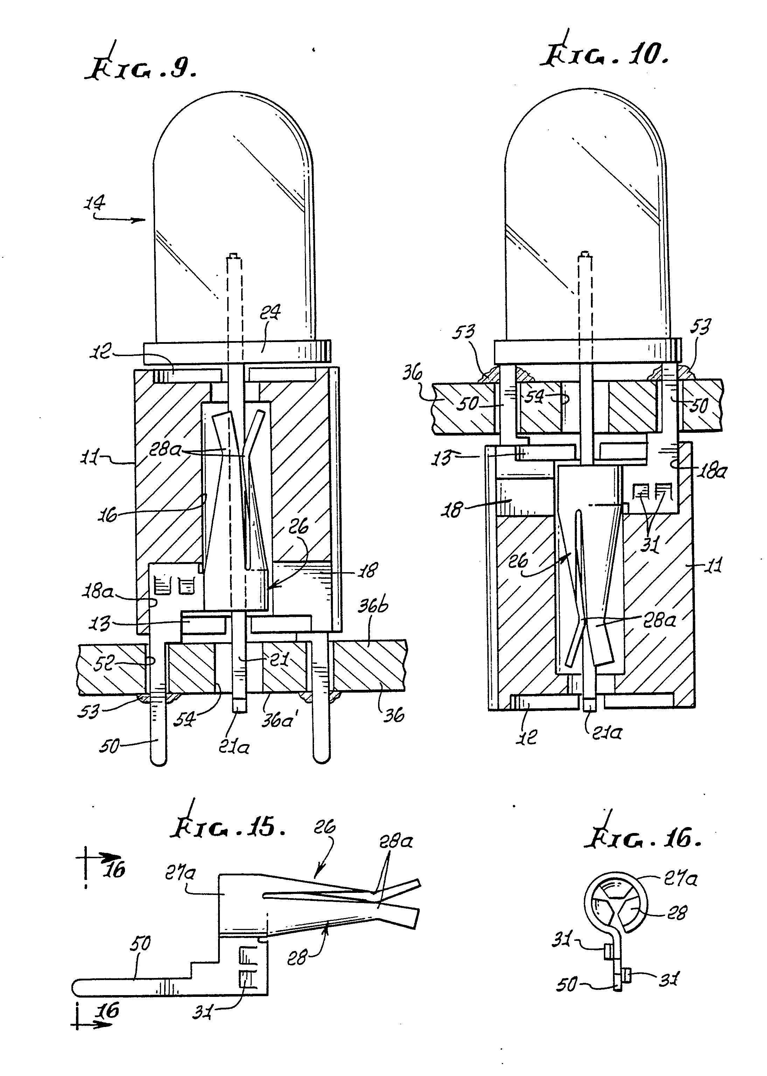

A circuit component with terminals is adapted to be supported by the body, the illustrated component such as light unit 14 comprising an LED (or other light unit such as an incandescent lamp or Neon lamp). Unit 14 has two terminals 21 projecting rearwardly from a housing 22, and also within the latter. A luminous chip 23 defines the light emitting zone of the LED. A base flange or arcuate boss is shown at 24, and it flatly engages the end wall 13a of the mount, in Figure 4, which surrounds recess 13.

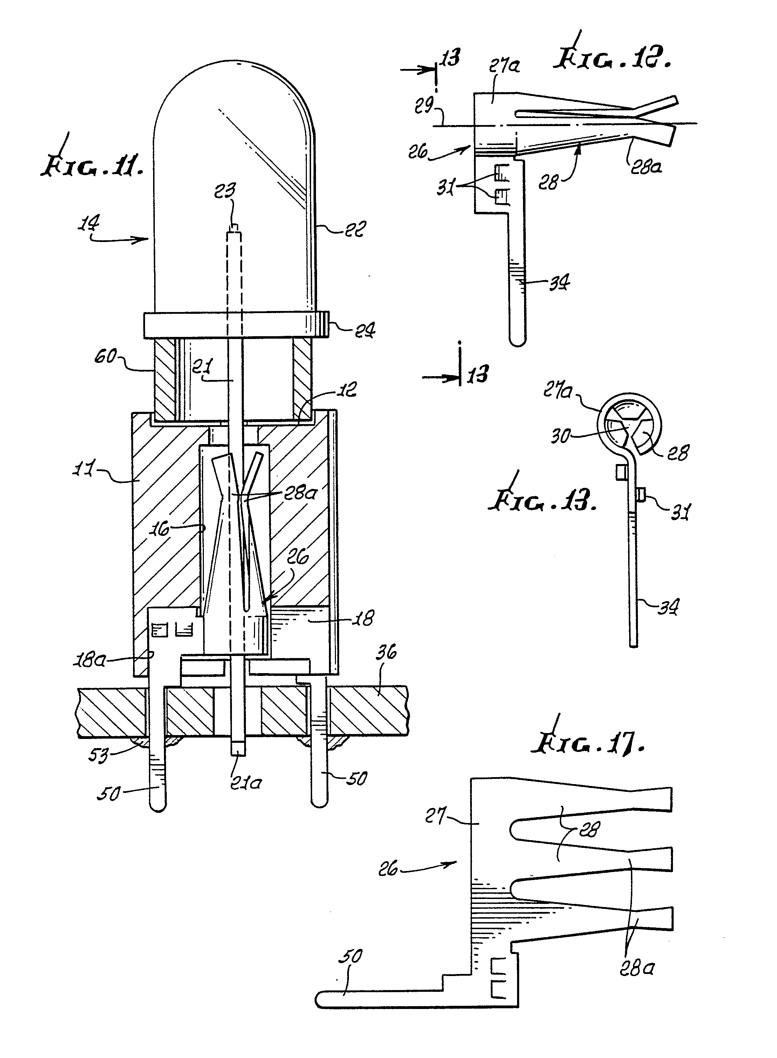

The mount 10 also includes contact structure in the body cavity means for removable endwise reception of the terminal means such as terminals 21, to establish electrical contact with same when the base 24 is supported by the body end portion, in the position of the unit 14 at one end of the body (see Figure 5). See for example the contact structure 26 illustrated in Figures 12 to 14. It includes a contact body 27 in the form of single electrically conductive, flat (as-stamped) metallic sheet from which laterally spaced spring fingers 28 project longitudinally, in Figure 14. In Figures 12 and 13 the sheet 27 has been rolled into generally circular arc 27a to locate the three fingers about axis 29, at 120° intervals. Also in Figures 12 and 13 the fingers have been deformed to taper rightwardly so that their narrowed portions 28a define a reception zone 30 for a terminal 21, to forcibly grip the latter upon its endwise insertion, as in Figures 4 and 5. These views also show the contact structure inserted into a cavity 16. Tabs 31 on the contact structure are received into cavities 17 and 18 anchor the contact structure in position, and the cavities 17 and 18 may receive insulative bonding agent, such as an epoxy resin, to add to the anchoring objective. Note that rolled arcuate section 27a is closely received in the cavity bore to centre the contact structure and the fingers, for axial reception of the terminal. Two such contact structures 26 are shown in the two cavities 15 and 16, in Figures 1 to 4.

Auxiliary terminal means 34 also project sidewardly out of the body 11, and typically closer to body end 13a than to body end 12a. The terminal means 34 may be integral with the contact structure 26, as seen in Figures 12 to 14, and it projects via cavity 18 in body 11 and an axial slot 80 in the body, to the exterior, for reception by a circuit board 36. A bridge portion of the stamping contacts 26 and 34 has tabs 81 that interfit the walls of slot 80. Figure 4 show board 36 having an opening 36a passing the terminal 34, and solder 37 anchoring the pin or terminal 34 in the position shown. Sheet solder at side 36b of the board may also be employed. Other circuitry connected to terminal 34 is schematically shown at 39. Ribs 40 on body side 19 engage the upper side 36b of the board, whereby the mount is ruggedly attached to the board, with light unit 14 extending parallel thereto. Also, the body is thereby raised from the board to allow tapped flux to be washed away.

In Figure 5, the light unit takes the form of an incandescent lamp 140 attached to the opposite end 12a of the mount body 11 as shown (of course, any LED or other electrically compound could alternatively be employed, in place of unit 140). The unit 140 has a housing 141 with a base 141a engaging mount end 12a. The two terminals 142 of the unit 140 project endwise into electrical contact with the gripping spring finger portions 28a. The ends 142a of the terminals may be bent for retaining the terminals and light unit in position i.e. against withdrawal from contacts 28a. In similar manner, in Figure 4, the ends 21a of terminal 21 may be bent for retaining the unit 14 against withdrawal from the spring finger contacts. Wire 143 is adapted to becomes luminous, within glass envelope 144, when electrical current is delivered via terminals 34 to wire 143.

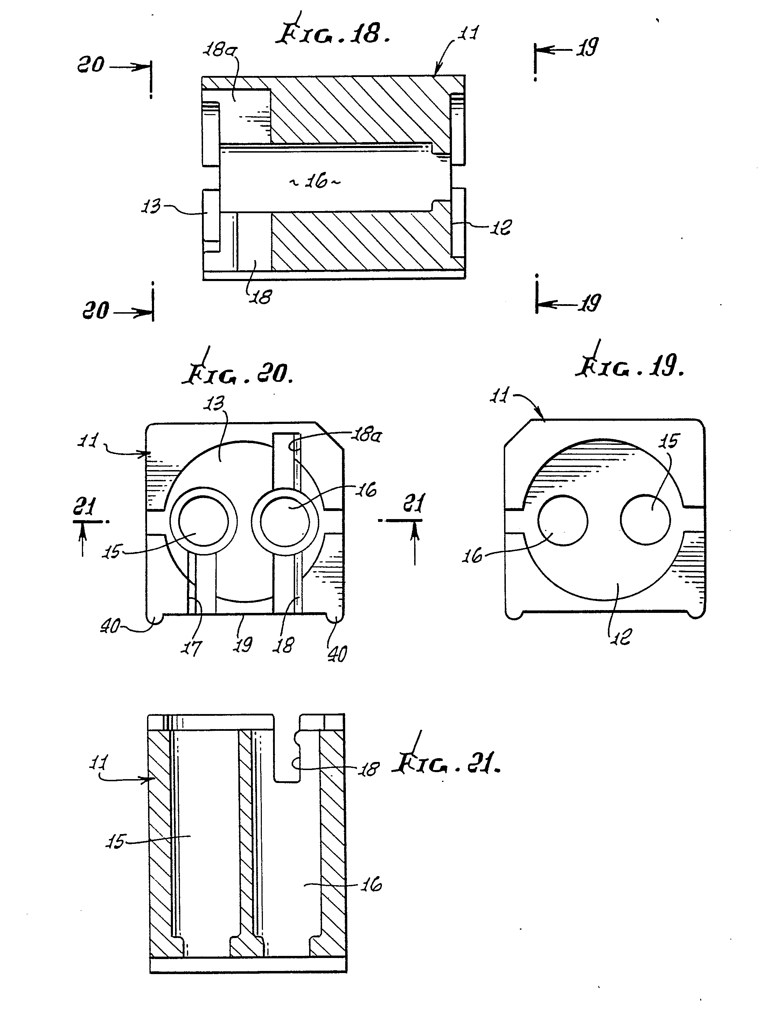

Referring now to Figures 6 to 10, and 15 to 17, the structure of the mount body 11 remains the same whereby the mount is "universal" as respect the different contact structure employed, and the different light units or their modes of mounting, at a selected end of the body. The contact structure body 27 and fingers 28 also remain the same; however, the terminal 50 (corresponding to terminal 34) projects endwise or longitudinally instead of sidewardly, at one lateral end of body 27. Consequently, the two terminals 50 extends endwise of the body 11 in Figures 6 to 10. As a further consequence, and as shown in Figure 9 to 10, the light unit and body are enabled to project endwise upright from the circuit board 36, should that mode of mounting be desired. In Figure 9, the light unit 14 (LED) projects upwardly remotely, from the upper side 36b of the board 36; contact terminals 50 project through the board openings 52 to be soldered at 53; and light unit terminals 21 project through intermediate board openings 54; and ends 21a of the terminals 21 may be turned for retention at board side 36a'.

In Figure 10, the structure is like that shown in Figure 9, except that the mount 11 and light unit 14 are at opposite sides of the board 36. The mounting of the body 11 to the board is the same as in Figure 9, except that contact terminals 50 are cutoff proximate the loci of the solder connections 53. The base 24 of the light unit now is located near or seated on the solder connections 53, or the ends of the terminals 50 so that the light unit terminals project back through openings 54 in the board; and into contact with the spring fingers 28, at the opposite side of the boards. Ends 21a may be turned, as shown, for retention.

In Figure 11, the structure is the same as in Figure 9, excepting that a spacer 60 is located between the light unit base 24 and end portion 12 of the body 11. The spacer extends about terminal 21; and it fits into the recess defined by the end of body 11, for positioning and retention, the end 21a of the terminal 21 being typically turned to provide such retention. Note also offsets 80 integral with the contact structures and spacing the body from the base.

## Claims

1. For use in an assembly including a circuit component having a base and terminal means projecting endwise from the base the combination comprising:

    a) a body having at least one end portion adapted to provide support for the base of the circuit component,

    b) the body defining cavity means, there being contact structure in the cavity means for removable endwise reception of the circuit component terminal means to establish electrical contact therewith when the base of the circuit component is supported by the body end portion,

c) and auxiliary terminal means carried by the body and projecting exteriorly therefrom for reception by a circuit board, thereby to mount the body and circuit component on the circuit board, the auxiliary terminal means having electrical connection with the contact structure,

d) the contact structure including spring fingers spaced about a zone or zones adapted to receive the circuit component terminal means in electrical contact therewith

e) the contact structure and the auxiliary terminal means being integral and attached to the body, which is insulative,

f) the integral contact structure and auxiliary terminal means being defined by a single metallic sheet having tab means anchoring the sheet to the body, and the sheet having a bridge portion between the contact structure and the auxiliary terminal means, the bridge portion mounting the tab means which is or are deflected sidewardly from a plane defined by the bridge portion, the plane extending axially of the body;

g) the body defining an axially extending slot receiving said bridge portion.

2. Apparatus according to claim 1 wherein the cavity means extends through the body and opens at opposite ends defined by the body to expose the contact structure to endwise reception of the terminal means via one or other of the opposite ends.

3. Apparatus according to claim 2 wherein the auxiliary terminal means projects sidewardly, outwardly of the body, and closer to one of the body ends than the other of the body ends.

4. Apparatus according to claim 3 including the circuit component having its base located at the said one end of the body, with the circuit component terminal means in electrical contact with the contact structure, within the cavity means.

5. Apparatus according to claim 3 including the circuit component having its base located at the other end of the body, with the circuit component terminal means in electrical contact with the contact structure, within the cavity means.

6. Apparatus according to claim 2 wherein the auxiliary terminal means projects endwise of and from one end of the body.

7. Apparatus according to claim 6 including the circuit component having its base located at an opposite end of the body, with the circuit component terminal means in electrical contact with the contact structure within the cavity means.

8. Apparatus according to claim 2 wherein the cavity means includes two spaced, generally parallel cavities respectively containing first and second contacts defined by the contact structure, the contacts including spring fingers to pressurally engage first and second light unit terminals respectively received in the first and second cavities.

9. Apparatus according to claim 1 wherein the said one end portion is recessed to provide the support for the base of the circuit component.

10. Apparatus according to claim 9 including the base received in the recessed end portion.

11. Apparatus according to claim 9 including a spacer received in the said end portion, and the base carried by the spacer.

12. Apparatus of any one of claims 4, 5, 7, 10 and 11 wherein the circuit component terminal means projects at least substantially through the cavity and has an end portion remote from the base and retained by the body against relative displacement endwise of the cavity.

13. Apparatus according to claim 1 including the circuit component with its terminal means projecting at least substantially through the cavity and having an end portion thereof remote from the base which is deformed to be retained by the body against relative displacement endwise of the cavity.

14. Apparatus according to claim 1 including the circuit board having an opening or openings receiving the auxiliary terminal means.

15. Apparatus according to claim 14 including solder retaining the auxiliary terminal to the board.

16. Apparatus according to claim 14 wherein the cavity means is elongated and extends parallel to the board.

17. Apparatus according to claim 14 wherein the cavity means is elongated and extends perpendicular to the board.

18. Apparatus according to claim 17 including the circuit component having its base located at the said one end of the body, with the circuit component terminal means in electrical contact with the contact structure within the cavity means.

19. Apparatus according to claim 18 wherein the circuit component terminal means also projects through an opening in the board.

20. Apparatus according to claim 20 wherein the body and the circuit component are at opposite sides of the circuit board.

FIG.1.

FIG.3.

FIG.2.

FIG. 4.

FIG. 5.

FIG.6.

FIG.8.

FIG.7.

FIG.14.

FIG.9.

FIG.10.

FIG.15.

FIG.16.

0 200 462

FIG.11.

FIG.12.

FIG.13.

FIG.17.

FIG.18.

FIG.20.

FIG.19.

FIG.21.